## Europäisches Patentamt
## European Patent Office
## Office européen des brevets

(19)

(11) Veröffentlichungsnummer: **0 010 552**
**B1**

(12) **EUROPÄISCHE PATENTSCHRIFT**

(45) Veröffentlichungstag der Patentschrift: **24.08.83**

(21) Anmeldenummer: **78101222.4**

(22) Anmeldetag: **25.10.78**

(51) Int. Cl.³: **H 04 B 17/00, H 03 J 3/14, H 04 B 1/16, G 05 B 1/00**

(54) Verfahren und Schaltungsanordnung zum Messen der Empfangsqualität eines frequenzmodulierten UKW-Signals.

(43) Veröffentlichungstag der Anmeldung:
**14.05.80 Patentblatt 80/10**

(45) Bekanntmachung des Hinweises auf die Patenterteilung:
**24.08.83 Patentblatt 83/34**

(84) Benannte Vertragsstaaten:
**BE CH FR GB NL SE**

(56) Entgegenhaltungen:
DE - A - 2 334 807
DE - B - 1 952 739
US - A - 3 869 673

FUNKSCHAU, Vol. 43, September 1971 Heft 17 München, D. W. OPPERMANN: "UKW-Stereo-Tuner mit eingebautem Oszillografen", Seiten 549—550
AUDIO, Vol. 53, Nr. 3, März 1969 New York, U.S.A. L. FELDMAN: "ABZs of FM", Seiten 40, 42, 74.

(73) Patentinhaber: **Bossert, Theodor Tobias, Dipl.-Phys.**
**Buchenweg 10**
**D-8056 Neufahrn (DE)**

(72) Erfinder: **Bossert, Theodor Tobias, Dipl.-Phys.**
**Buchenweg 10**
**D-8056 Neufahrn (DE)**

(74) Vertreter: **Konle, Tilmar, Dipl.-Ing.**
**Institut für Rundfunktechnik GmbH**
**Floriansmühlstrasse 60**
**D-8000 München 45 (DE)**

Courier Press, Leamington Spa, England.

## Verfahren und schaltungsanordnung zum messen der empfangsqualität eines frequenzmodulierten UKW-signals

Die Erfindung bezieht sich auf ein Verfahren gemäß dem Oberbegriff des Anspruchs 1 sowie auf eine Schaltungsanordnung gemäß dem Oberbegriff des Anspruchs 2. Ein Verfahren und eine Schaltungsanordnung dieser Art sind aus der DE—OS 23 34 807 bekannt.

Bei dem Empfang von frequenzmodulierten Ultrakurzwellen (UKW-FM-Empfang) treten infolge der Mehrwegeausbreitung der Ultrakurzwellen Amplituden- und Phasenstörmodulationen auf, welche die Empfangsqualität beeinträchtigen. Für die Beurteilung der Empfangsqualität ist daher die Erfassung der genannten Störmodulationen unerläßlich. Hierbei kann NFseitig die Phasenstörmudulation nicht erfaßt werden, da während einer UKW-Sendung nicht feststellbar ist, welche Phasenänderungen zum Nutzsignal und welche Phasenänderungen dem Störsignal zuzuordnen sind. Demgegenüber stellt die Amplitudenstörmodulation einen verwertbaren Störeffekt dar, da UKW-Sender stets mit gleichbleibender Amplitude abstrahlen (scgenannte "Vollaussteuerung"), so daß Amplidenschwankungen nur durch Störungen verursacht werden können. Bei bekannten Verfahren zum Erfassen der Amplituden-Störmodulation (DE—OS—23 34 807, "Funkschau", Bd. 43 (1971), Heft 17, Seiten 549 bis 550 und Forschungsbericht der British Broadcasting Corporation BBC RD 1975/33 mit dem Titel "A field strength measuring receiver for band II") werden die entstehenden Amplitudenschwankungen des UKW-Signals dahingehend mit dessen Momentanfrequenz in Relation gesetzt, daß aud einem Oszilloskop in X-Richtung das frequenzdemodulierte NF-Signal (Momentanfrequenz) und in Y-Richtung die mit einem AM-Detektor gewonnene, durch Wellenreflexionen modulierte Amplitude des UKW-Signals dargestellt werden. Für die konstruktive Ausbildung des AM-Detektors sind in diesem Stand der Technik verschiedene Möglichkeiten vorgesehen. Bei dem Verfahren gemäß "Funkschau", 1971, wird ein AM-Detektor mit komprimierender (logarithmischer) Demodulations-Kennlinie verwendet, welche die Abbildung des gesamten, sehr großen Bereiches an möglichen UKW-Signalamplituden auf dem Oszilloskopschirm gestattet, so daß auf eine Regelung der ZF-Verstärkung verzichtet werden kann. Die abgebildete Funktion A $(\omega)$ erlaubt jedoch wegen der nichtlinearen Demodulations-Kennlinie nur eine quantitative Bewertung der Störmodulation. Demgegenüber ist in den beiden anderen Literaturstellen als AM-Detektor ein AM-Demodulator mit linearer Kennlinie vorgesehen. In diesem Falle ist eine Regelung der ZF-Verstärkung von Hand (BBC-Forschungsbericht) oder durch eine AGC (DE-OS—23 34 807) erforderlich, um den sehr großen Bereich an möglichen UKW-Signalamplituden an den zwangsläufig begrenzten Dynamikbereich des AM-Demodulators anzupassen. Infolge dieser Verstärkungsregelung entspricht das Ausgangssignal des AM-Demodulators nicht der Amplitude des UKW-Signals, sondern einer durch die Regeleigenschaften normierten, d.h., auf einem Referenzpegel bezogenen Amplitude.

Im Falle der manuellen Regelung der ZF-Verstärkung (BBC-Forschungsbericht) muß die Verstärkung so gewählt werden, daß die Bezugsachse der von dem Oszilloskop wiedergegebenen Kurve deckungsgleich mit der Abszisse des auf dem Oszilloskopschirm aufgebrachten Skalenkreuzes ist. Die Bezugsachse der Kurve ist dabei eine gedachte Linie, welche der Kurve bei fehlenden Reflexionen entspricht. Bei jeder Änderung der UKW-Signalamplitude, beispielsweise infolge der Drehung der Antenne zur Optimierung der Antennenausrichtung, muß diese Normierung neu durchgeführt werden, was mühsam und zeitraubend ist.

Zur Regelung der ZF-Verstärkung mittels einer AGC (DE—OS—23 34 807) können entweder der Mittelwert oder Spitzenwert der Amplitude oder der Spektralanteil des UKW-Trägers als Pegelparameter benutzt werden. Indessen sind durch Mehrwegeausbreitung des UKW-Signals entstehende Amplitudenschwankungen im Gegensatz zu den in der Übertragungstechnik bekannten Amplitudenmodulationen so geartet, daß keiner der genannten Parameter des UKW-Signals konstant ist, sondern mit der Aussteuerung der Frequenzmodulation (Frequenzhub) variieren. Die Benutzung eines dieser Parameter für die automatische Regelung der ZF-Verstärkung führt deshalb zwangsläufig zu laufenden Anderungen der Normierung das Ausgangssignals des AM-Demodulators in Abhängigkeit von der Aussteuerung der Frequenzmodulation (Frequenzhub). Hierdurch läßt sich mit dem bekannten Verfahren nach der DE—OS—23 34 807 die Empfangsstörung ebenfalls nur qualitativ, nicht aber quantitativ beurteilen.

Die Aufgabe der Erfindung besteht demgegenüber darin, ein Verfahren und eine Schaltungsanordnung der eingangs erwähnten Art dahingehend zu verbessern, daß die durch Mehrwegeausbreitung von UKW-Signalen verursachten Empfangsstörungen rasch und mühelos gemessen, d.h., quantitativ beurteilt werden können.

Diese Aufgabe wird erfindungsgemäß durch die kennzeichnenden Merkmale des Anspruchs 1 (Verfahren) bzw. des Anspruchs 2 (Schaltungsanordnung) gelöst.

Vorteilhafte Ausgestaltungen und Weiterbildungen der Schaltungsanordnung nach Anspruch 2 ergeben sich aus den Ansprüchen 3 bis 7.

Die erfindungsgemäße Aufgabenlösung beruht auf der Erkenntnis, daß sich die erwähnten Änderungen der Normierung in Abhängigkeit von dem Frequenzhub bei Verwendung einer automatischen ZF-Verstärkungsregelung dadurch vermeiden lassen, daß der momentane Amplitudenwert des UKW-Signals im Augenblick des momentanen Frequenzhubes "Null" erfaßt und als Regelkriterium herangezogen wird. Dieses Regelkriterium ist unabhängig von der Aussteuerung der Frequenzmodulation, so daß die normierte Amplitude $A/A_0$ am Ausgang des AM-Demodulators erstmals für Meßzwecke verwendet werden kann. Die Extremwerte der Ableitung dieser normierten Signalamplitude nach der Frequenz des UKW-Signals stellen dabei ein direktes Maß für den Grad reflexionsbedingter NF-Störungen des UKW-Signals und damit ein direktes Maß für die Empfangsqualität dar.

Die Erfindung wird anhand der Zeichnungen näher erläutert. Es zeigt:

Fig. 1A ein Blockschaltbild der linken Hälfte eines Ausführungsbeispiels für eine erfindungsgemäße Schaltungsanordnung;

Fig. 1B ein Blockschaltbild der rechten Hälfte des Ausführungsbeispiels für die erfindungsgemäße Schaltungsanordnung;

Fig. 1C eine schematische Darstellung für die richtige Zusammenfügung der Blockschaltbilder gemäß Fig. 1A und Fig. 1B, und

Fig. 2 eine Ansicht einer auf dem Oszillographenschirm eines in dem Blockschaltbild nach Fig. 1B vorhandenen Kathodenstrahloszillographen weidergegebenen Kurve, welche den Amplitudenverlauf eines störmodulierten UKW-Signals in Abhängigkeit von der UKW-Signalfrequenz darstellt.

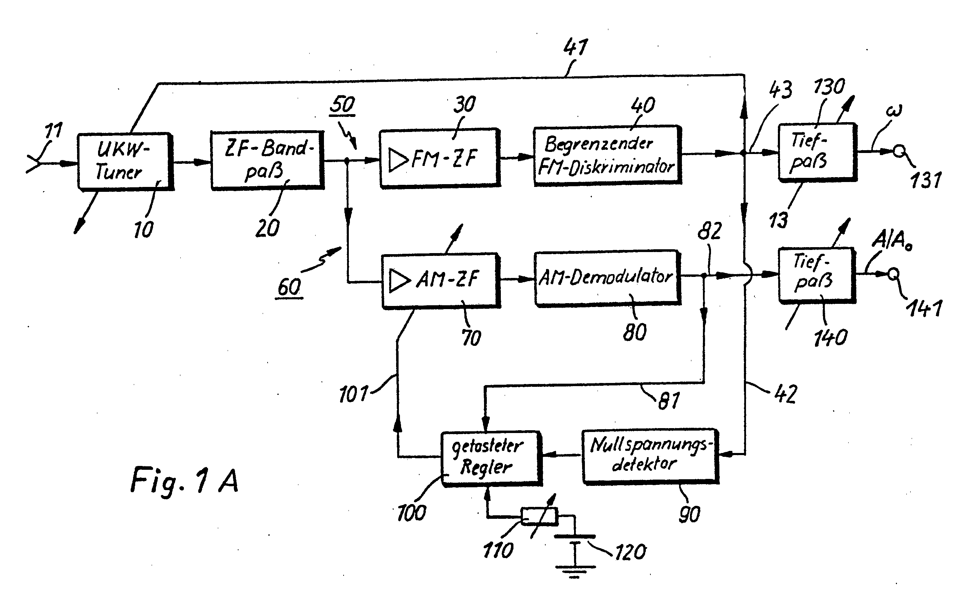

Die in Fig. 1A anhand eines Blockschaltbildes veranschaulichte linke Hälfte eines Ausführungsbeispieles der erfindungsgemäßen Meßeinrichtung besteht zu einem Großteil aus einem bekannten UKW-Empfänger, der für die erfindungsgemäßen Zwecke ergänzt wurde. Im einzelnen weist das Blockschaltbild gemäß Fig. 1A einen UKW-Tuner 10 auf, welcher von einer Antenne 11 mit einem frequenzmodulierten UKW-Signal gespeist wird. Dem UKW-Tuner 10 ist in üblicher Weise ein ZF-Bandpaß nachgeschaltet, welcher das in dem Tuner 10 auf eine Zwischenfrequenz umgesetzte UKW-Signal durchläßt. Der Ausgang des Bandpasses 20 gebelt sich in zwei Signalzweige 50 und 60. Der Signalzweig 50 enthält einen FM-Zwischenfrequenzverstärker 30, dem ein begrenzender FM-Diskriminator 40 nachgeschaltet ist. Der Signalzweig 60 enthält einen AM-Zwischenfrequenzverstärker 70, dem ein AM-Demodulator 80 nachgeschaltet ist. Der Verstärker 70 ist regelbar, wofür ein Regler 100 vorgesehen ist, dessen Ausgang über eine Leitung 101 mit dem Steuereingang des Verstärkers 70, dessen Istwert-Eingang über eine Leitung 81 mit dem Ausgang des Demodulators 80 und dessen Sollwerteingang mit einem aus einer Gleichspannungsquelle 120 und einem seriengeschalteten Potentiometer 110 bestehenden Sollwertsteller verbunden ist. Der Regler 100 wird von einem Nullspannungsdetektor 90, z.B. einem Fensterdiskriminator getastet, dessen Eingang über eine Leitung 42 mit dem Ausgang des Diskriminators 40 verbunden ist. Des weiteren wird das Ausgangssignal des Diskriminators 40 über eine Leitung 41 auf den Regeleingang des UKW-Tuners 10 rückgekoppelt. Der Diskriminator 40 und der Demodulator 80 führen über Leitungen 43 bzw. 82 zu jeweils einem bandbreitenvariablen Tiefpaß 130 bzw. 140, an deren Ausgänge ein dem momentanen Frequenzhub $\omega$ bzw. ein der normierten, auf einen Referenzwert $A_0$ bezogenen UKW-Signalamplitude

$$\frac{A}{A_0}$$

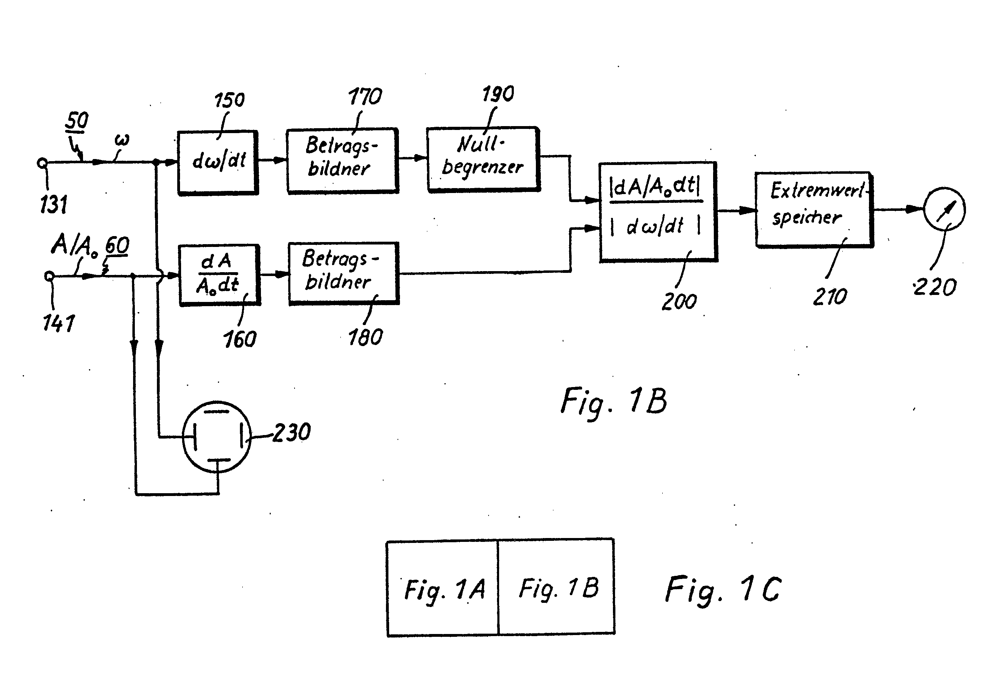

entsprechendes Signal anliegt, wobei der Referenzwert $A_0$ der Amplitude des UKW-Signals bei Nichtanwesenheit von Reflexionen entspricht. Diese Signale an den Ausgängen 131 und 141 der Tiefpässe 130 bzw. 140 werden der in Fig. 1B varanschaulichten rechten Hälfte des betrachteten Ausführungsbeispiels für die erfindungsgemäße Meßeinrichtung zugeführt. Zur besseren Orientierung ist die richtige Zusammenfügung der Blockschaltbilder gemäß Fig. 1A und 1B in Fig. 1C schematisch dargestellt.

Wie aus Fig. 1B im einzelnen ersichtlich ist, ist der im Signalzweig 50 liegende Ausgang 131 des Tiefpasses 130 mit einem Differenzierglied 150 verbunden, welches die Ableitung

$$\frac{d\omega}{dt}$$

des Frequenzhubsignals $\omega$ nach der Zeit $t$ bildet. In ähnlicher Weise ist auch der Ausgang 141 des Tiefpasses 140 mit einem Differenzierglied 160 verbunden, welches die Ableitung

$$\frac{dA}{A_0 dt}$$

des normierten Amplitudensignals

$$\frac{A}{A_0}$$

nach der Zeit $t$ bildet. Das am Ausgang des Differenziergliedes 150 erzeugte Signal für den Differentialquotienten

$$\frac{d\omega}{dt}$$

wird über einen z.B. aus einem Brückengleichrichter und einem Operationsverstärker bestehenden Betragsbildner 170 und einen nachgeschalteten Nullbegrenzer 190 dem ersten Eingang eines Dividierers 200 zugeführt, wohingegen das am Ausgang des Differenziergliedes 160 erzeugte Signal für den Differentialquotienten

$$\frac{dA}{A_0 dt}$$

über einen dem Betragsbildner 170 entsprechenden Betragsbildner 180 unmittelbar dem zweiten Eingang des Dividierers 200 zugeführt wird. Der Dividierer 200 bildet den Quotienten

$$\frac{\left|\dfrac{dA}{A_0 dt}\right|}{\left|\dfrac{d\omega}{dt}\right|} = \left|\frac{\partial A}{A_0 \partial \omega}\right|$$

Der Nullbegrenzer 190 verhindert, daß der im Nenner des genannten Quotienten stehende Ausdruck

$$\left|\frac{d\omega}{dt}\right|$$

zu Null und damit der Quotient unendlich groß wird. Das Ausgangssignal des Dividierers 200 entspricht betragsmäßig dem gesuchten Quotienten

$$\frac{\delta A}{A_0 \delta \omega}$$

d.h., daß die Extremwerte des Ausgangssignals des Dividierers 200 ein unmittelbares Maß für die Empfangsqualität des an der Antenne 11 (Fig. 1A) ankommenden, störmodulierten UKW-Signals darstellen. Das Ausgangssignal des Dividierers 200 wird einem Extremwertspeicher 210, beispielsweise einem Emitterfolger mit Kondensator, zugeleitet, der die Extremwerte des Dividierer-Ausgangssignals ermittels und einem digitalen oder analogen Anzeigegerät 200, beispielsweise einem Spannungsmeßinstrument, zuführt.

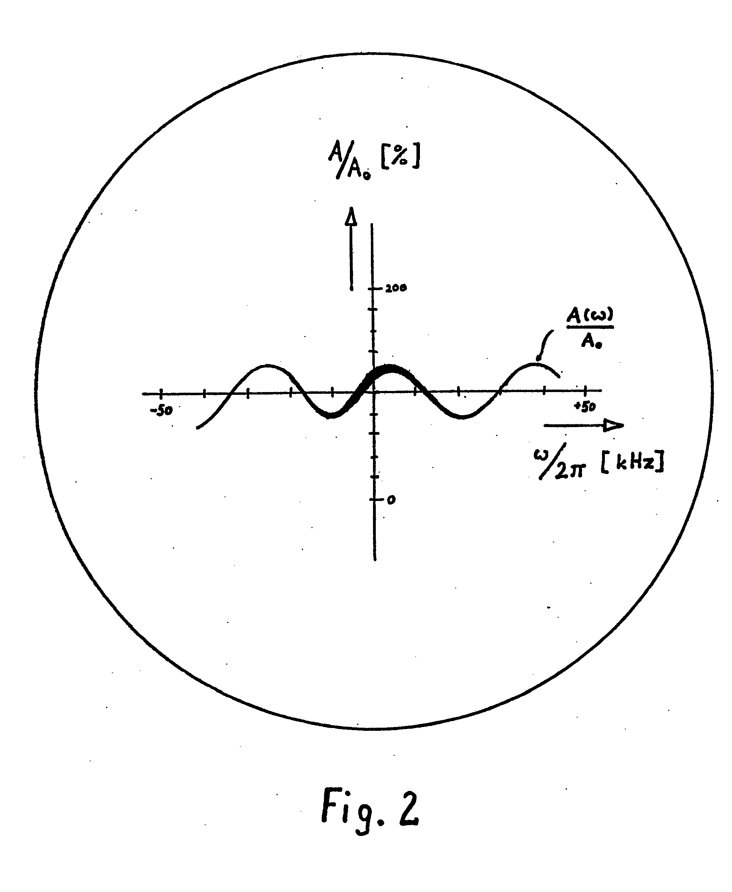

Der erwähnte Differentialquotient kann auch dadurch ermittelt werden, daß die an den Ausgängen 131 und 141 der Tiefpaßfilter 130 bzw. 140 anliegenden Signale den X- bzw. Y-Ablenkeinrichtungen eines Kathodenstrahloszillographen 230 zugeführt werden. Der Kathodenstrahlozillograph 230 erzeugt auf seinem Schirm die für einen einfachen Fall in Fig. 2 veranschaulichte Kurve A(ω)/A₀, deren Steigung dem gesuchten Differentialquotienten entspricht.

Für die beschriebene Ermittlung des erwähnten Differentialquotienten entweder mit Hilfe der Schaltungssteile 150, 160, 170, 180, 190, 200, 210, 220 oder mit Hilfe des Oszillographen 230 ist in jedem Falle entscheidend, daß die Bezugsgröße A₀ des am Ausgang des Demodulators 80 (Fig. 1A) anliegenden normierten Amplitudensignals

$$\frac{A}{A_0}$$

während des gesamten Meßvorganges gültig bleibt, und zwar auch dann, wenn sich die Empfangsverhältnisse beispielsweise durch Verdrehen der Empfangsantenne 11 ändern. Diesem Zweck dient die aus den Schaltungsteilen 70, 80, 81, 90, 100, 101 bestehende Regelschleife, mit Hilfe derer nur die Amplitude bei dem momentanen Frequenzhub "Null" auf einen konstanten Wert geregelt wird, dagegen die normierte Amplitude

$$\frac{A}{A_0}$$

des AM-Signals unbeeinflußt gelassen wird. Diese getastete Regelung wird durch den Nullspannungsdetektor 90 ermöglicht, welcher feststellt, wann das dem momentanen Frequenzhub ω proportionale Ausgangssignal des Diskriminators 40 zu Null wird. Ein momentaner Frequenzhub ω=0 bedeutet, daß am Ausgang des Bandpasses 20 ein Signal vorliegt, dessen momentane Frequenz gleich der ZF-Trägerfrequenz ist. In Abhängigkeit von der genannten Feststellung durch den Detektor 90 wird der Regler 100 eingetastet bzw. aktiviert, so daß die zum Eintastzeitpunkt an seinem Istwert-Eingang anliegende Signalamplitude voraussetzungsgemäß das Regelkriterium darstellt. Dieser Istwert wird in üblicher Weise mit dem am Potentiometer 110 eingestellten Sollwert verglichen, wobei das hieraus resultierende Fehlersignal von dem Regler 100 entsprechend seiner Regelkennlinie in ein Stellsignal für den Verstärker 70 umgesetzt wird. Sobald der Detektor 90 einen von Null verschiedenen momentanen Frequenzhub ω am Ausgang des Diskriminators 40 feststellt, tastet er den Regler 100 aus, wodurch bis zur nächstfolgenden Eintastung des Reglers 100 die zum Austastzeitpunkt vorhandene Verstärkungseinstellung des Verstärkers 70 unverändert bleibt.

Durch die Konstantregelung der Amplitude bei dem momentanen Frequenzhub "Null" und durch geeignete Wahl des Regler-Sollwertes am Potentiometer 110 wird erreicht, daß die Normierung der Amplitude A auf die Bezugsgröße A₀ während des gesamten Meßvorganges konstant gehalten wird. Im Falle der Wiedergabe der Funktion

$$\frac{A(\omega)}{A_0}$$

auf dem Schirm des Kathodenstrahloszillographen 230 kann durch geeignete Wahl des
Regler-Sollwertes am Potentiometer 110 die
Bezugsgröße mit der Skalenabszisse des dort
aufgetragenen Skalenkreuzes zur Deckung
gebracht werden (Fig. 2). Die durch die konstante Regelung der Bezugsgröße erreichte
Meßgenauigkeit wird noch weiter dadurch
erhöht, daß die bandbreitenvariablen Tiefpässe
130 bzw. 140 rauscharme Signale an den Eingängen der Differenzierglieder 150, 160 bzw.
an den X-, Y-Ablenkeinrichtungen des
Kathodenstrahloszillographen 230 abgeben,
ohne die zeitliche Korrelation beider Signale zu
verwischen.

Die Funktionsweise der Schaltungsteile 10,
20, 30 und 40 des Blockschaltbildes nach Fig.
1A ist aus üblichen UKW-Empfängern bekannt
und bedarf keiner näheren Erläuterung.

## Patentansprüche

1. Verfahren zum Messen der Empfangsqualität eines frequenzmodulierten UKW-
Signals, wobei die durch Wellenreflexionen
modulierte Amplitude A und die Frequenz $\omega$ des
UKW-Signals getrennt ermittelt werden und
hieraus ein Kriterium für das Maß der Empfangsqualität abgeleitet wird, dadurch gekennzeichnet, daß zur Ermittlung des Quotienten
$A/A_0$ der momentane Frequenzhub "Null" des
UKW-Signals erfaßt (40, 90) und in Abhängigkeit von dieser Nullerfassung eine Verstärkungsregelung (100) für den Signalzweig (70,
80) zur Ermittlung der UKW-Signalamplitude
(A) aktiviert wird, wobei $A_0$ die Amplitude des
empfangenen UKW-Signals bei Nichtanwesenheit von Reflexion und bei dem momentanen
Frequenzhub "Null" ist, und daß die Ableitung
des Quotienten $A/A_0$ nach der Frequenz $\omega$
gebildet wird, deren Maximalwerte unmittelbar
das Maß für die Empfangsqualität darstellen.

2. Schaltungsanordnung zum Messen der
Empfangsqualität eines frequenzmodulierten
UKW-Signals, mit einer Kettenanordnung aus
einem eingangsseitigen UKW-Tuner (10), einem
Bandpaß (20) und einer Signalverzweigung,
welche einen ersten Signalzweig (50) mit einem
FM-Zwischenfrequenzverstärker (30) und einem
begrenzenden FM-Diskriminator (40) sowie
einen zweiten Signalzweig (60) mit einem
regelbaren AM-Zwischenfrequenzverstärker (70)
und einem AM-Demodulator (80) aufweist, gekennzeichnet durch eine Regelschleife
(70, 80, 81, 100, 101) für den AM-Zwischenfrequenzverstärker (70), welche von einem
Detektor (90) für den momentanen Frequenzhub "Null" des UKW-Signals aktivierbar ist und
daß eine Einrichtung (130, 140, 230; 130, 140,
150, 160, 170, 180, 190, 200, 210, 220) zur
Bildung der Ableitung des geregelten Ausgangssignals ($A/A_0$) des AM-Demodulators (80)
nach der Ausgangsspannung des FM-Diskriminators (Frequenz des empfangenen UKW-
Signals) vorgesehen ist.

3. Shaltungsanordnung nach Anspruch 2, dadurch gekennzeichnet, daß die Einrichtung
(130, 140, 230) folgende Merkmale aufweist:

— Ein mit dem Ausgang des FM-Diskriminators (40) verbundenes, erstes Tiefpaßfilter (130);
— ein mit dem Ausgang des AM-Demodulators (80) verbundenes zweites Tiefpaßfilter (140), und
— ein Kathodenstrahloszillograph (230),
dessen X-Ablenkeinrichtung mit dem ersten
Tiefpaßfilter (130) und dessen Y-Ablenkeinrichtung mit dem zweiten Tiefpaßfilter (140)
verbunden ist.

4. Schaltungsanordnung nach Anspruch 2,
dadurch gekennzeichnet, daß die Einrichtung
(130, 140, 150, 160, 170, 180, 190, 200, 210,
220) folgende Merkmale aufweist:

— Ein mit dem Ausgang des FM-Diskriminators (40) verbundenes, erstes Tiefpaßfilter (130);
— ein mit dem Ausgang des AM-Demodulators (80) verbundenes zweites
Tiefpaßfilter (140);
— ein erstes Differenzierglied (150), welches
dem ersten Tiefpaßfilter (130) nachgeschaltet ist;
— ein zweites Differenzierglied (160), welches
dem zweiten Tiefpaßfilter (140) nachgeschaltet ist;
— ein erster Betragsbildner (170), welcher dem
ersten Differenzierglied (150) nachgeschaltet ist;
— ein zweiter Betragsbildner (180), welcher
dem zweiten Differenzierglied (160) nachgeschaltet ist;
— ein Nullbegrenzer (190), welcher dem ersten
Betragbildner (170) nachgeschaltet ist;
— ein Dividierer (200), welcher eingangsseitig
mit dem Nullbegrenzer (190) und dem
zweiten Betragsbildner (180) verbunden ist
und ausgangsseitig über einen Extremwertspeicher (210) zu einem Anzeigegerät (220)
führt.

5. Schaltungsanordnung nach einem der Ansprüche 2 bis 4, dadurch gekennzeichnet, daß
als Betragsbildner (170, 180) jeweils ein
Brückengleichrichter mit einem Operationsverstärker vorgesehen ist.

6. Schaltungsanordnung nach einem der Ansprüche 2 bis 5, dadurch gekennzeichnet, daß
als Extremwertspeicher (210) ein Emitterfolger
und ein Kondensator vorgesehen ist.

7. Schaltungsanordnung nach einem der Ansprüche 2 bis 6, dadurch gekennzeichnet, daß
als Anzeigegerät (220) ein Spannungsmeßinstrument vorgesehen ist.

## Revendications

1. Procédé pour mesurer la qualité de réception d'un signal à OUC modulé en fréquence, où l'amplitude modulée A par des réflexions d'ondes et la fréquence $\omega$ du signal à OUC sont relevées séparément, en dérivant un critère pour le degré de la qualité de réception, caractérisé en ce que pour la constatation du quotient $A/A_0$ le déviation de fréquence "zéro" du signal à OUC instantanée est saisi (40, 90) et, sous la dépendance de cette saisie de zéro, un réglage de gain (100) pour une branche de signaux (70, 80), en vue de mettre en évidence l'amplitude à OUC (A), est activé, cependant qu' $A_0$ est l'amplitude du signal à OUC reçu à l'absence de réflexion et à l'instant du déviation de fréquence instantanée "zéro", et que la dérivée du quotient $A/A_0$ est formée selon la fréquence $\omega$, dont les valeurs maximales représentent directement le degré de la qualité de réception.

2. Circuit pour mesurer la qualité de réception d'un signal à OUC modulé en fréquence, qui comprend une chaîne composée d'un bloc d'accord à OUC côté entrée (10) d'un passe-bande (20) et d'une bifurcation à signaux, cette dernière comprenant une première branche à signaux (50) avec un amplificateur FI à modulation de fréquence intermédiaire (30) et un discriminateur FI limiteur (40), ainsi qu'une seconde branche à signaux (60) avec un amplificateur AM réglable à modulation de fréquence intermédiaire (70) et un démodulateur AM (80), caractérisé par une boucle de réglage (70, 80, 81, 100, 101) pour l'amplificateur AM à modulation de fréquence intermédiaire (70), la boucle étant susceptible à l'activation par un détecteur (90) pour déviation de fréquence "zero" du signal à OUC, et en ce qu'un système (130, 140, 230; 130, 140, 150, 160, 170, 180, 190, 200, 210, 220) est prévu pour former la derivée du signal régulé de sortie $A/A_0$ du démodulateur AM (80) selon la tension de sortie du discriminateur FI (fréquence du signal à OUC reçu).

3. Circuit suivant la revendication 2, caractérisé en ce que le système (130, 140, 230) présente des caractéristiques suivantes:

— Un premier filtre passe-bas (130) relié à la sortie du discriminateur FI (40),
— un second filtre passe-bas (140) relié à la sortie du démodulateur AM (80), et
— un oscillographe à rayons cathodiques (230), dont le système de déviation X est relié au premier filtre passe-bas (130) et dont le système de déviation Y est relié au second filtre passe-bas (140).

4. Circuit suivant la revendication 2, caractérisé en ce que le système (130, 140, 150, 160, 170, 180, 190, 200, 210, 220) présente des caractéristiques suivantes:

— Un premier filtre passe-bas (130) relié à la sortie du discriminateur FI (40);
— un second filtre passe-bas (140) relié à la sortie du démodulateur AM (80);

— un premier membre différentiateur (150) qui suit le premier filtre passe-bas (130);
— un second membre différentiateur (160) qui suit le second filtre passe-bas (140);
— un premier générateur de valeur absolue (170) qui suit le premier membre différentiateur (150);
— un second générateur de valeur absolue (180) qui suit le second membre différentiateur (160);
— un limiteur zéro (190) qui suit le premier générateur de valeur absolue (170);
— un diviseur (200) relié côté entrée au limiteur zéro (190) et au second générateur de valeurs absolue (180), et, côté sortie, amenant par une mémoire de valeur extrême (210) à un indicateur (220).

5. Circuit suivant une des revendications 2 à 4, caractérisé en ce qu'un redresseur en pont avec un amplificateur opérationnel est chaque fois prévu comme générateur de valeur absolue (170, 180).

6. Circuit suivant une des revendications 2 à 5, caractérisé en ce qu'un émetteur-suiveur et un condensateur sont prévus comme mémoire de valeur extrême (210).

7. Circuit suivant une des revendications 2 à 6, caractérisé en ce qu'un voltmètre est prévu comme indicateur (220).

**Claims**

1. A method for measuring the reception quality of a frequency modulated VHF signal, in which the amplitude that has been modulated by wave reflections and the frequency $\omega$ of the VHF signal are separately ascertained and therefrom derived a criterion of the degree of the reception quality, characterized in that

in order to ascertain the quotient $A/A_0$ the momentary frequency deviation "zero" of the VHF signal is detected (40, 90) and

in dependence on this zero detection there is activated an amplifying control (100) for the signal branch (70, 80) in order to ascertain the VHF signal amplitude (A),

wherein $A_0$ is the amplitude of the received VHF signal in absence of reflections and at the momentary frequency deviation "zero",

and further characterized in that the derivative of the quotient $A/A_0$ with respect to the frequency $\omega$ is formed, the maximum value of said derivative is directly forming the degree for the reception quality.

2. A circuitry for measuring the reception quality of a frequency modulated VHF signal, comprising a chain arrangement consisting of a VHF tuner (10) at the input end, a band-pass filter (20) and a signal branching, said signal branching comprises a first signal branch (50) with an FM intermediate-frequency amplifier (30) and a limiting FM discriminator (40) as well as a second signal branch (60) with an adjustable AM intermediate-frequency amplifier (70) and an AM demodulator (80), characterized by a control loop (70, 80, 81, 100, 101) for controlling the gain of the AM-IF amplifier (70), said control loop may be activated by a detector (90) for the momentary frequency deviation "zero" of the VHF signal, and a means (130, 140, 230; 130, 140, 150, 160, 170, 180, 190, 200, 210, 220) of forming the derivative of the adjusted output signal $(A/A_0)$ of the AM demodulator (80) in respect to the output voltage of the FM discriminator (the frequency of the received VHF signal).

3. A circuitry according to claim 2, characterized in that said means (130, 140, 230) comprise the following features:

— A first low-pass filter (130) being connected to the output of the FM demodulator (40);
— a second low-pass filter (140) being connected to the output of the AM demodulator (80);
— a cathode-ray oscillograph (230) whose X deflection device is connected to said first low-pass filter (130) and whose Y deflection device is connected to the second low-pass filter (140).

4. A circuitry according to claim 2, characterized in that said means (130, 140, 150, 160, 170, 180, 190, 200, 210, 220) comprise the following features:

— A first low-pass filter (130) being connected to the output of the FM demodulator (40);
— a second low-pass filter (140) being connected to the output of the AM demodulator (80);
— a first differentiator (150) being connected to the output of said first low-pass filter (130);
— a second differentiator (160) being connected to the output of said second low-pass filter (140);
— a first magnitude forming means (170) being connected to the output of said first differentiator (150);
— a second magnitude forming means (180) being connected to said second differentiator (160);
— a zero limiter (190) being connected to the output of said first magnitude forming means (170);
— a divider (200) being connected with its input to said zero limiter (190) and to said second magnitude forming means (180) and being connected with its output via an extreme value memory (210) to a display device (220).

5. A circuitry according to one of claims 2 to 4, characterized in that a bridge rectifier with an operational amplifier are provided for each of said magnitude forming means (170, 180).

6. A circuitry according to one of claims 2 to 5, characterized in that an emitter follower and a capacitor are provided for said extreme value memory (210).

7. A circuitry according to one of claims 2 to 6, characterized in that a voltage measuring instrument is provided for said display device (220).

Fig. 1 A

Fig. 1B

| Fig. 1A | Fig. 1B |

Fig. 1C

0010 552

Fig. 2